# EUROPEAN PATENT APPLICATION

(11) **EP 1 912 252 A1**
(43) Date of publication of application: **16.04.2008**
(21) Application number: 07117461.9
(22) Date of filing: 28.09.2007
(51) Int. Cl.: H01L 21/20

(54) **Polysilicon thin film transistor and method of fabricating the same**

(30) Priority: 13.10.2006 KR 20060099926
(71) Applicant: Samsung SDI Co., Ltd., Suwon-si Gyeonggi-do (KR)
(72) Inventor: Han, Gyoo-Wan Legal & IP Team, Samsung SDI Co., Ltd., Kyunggi-do (KR); Ryu, Sang-Gil University of California at Berkeley, Berkeley, CA 94720-1740 (US); Kim, Hyung-Sik Legal & IP Team, Samsung SDI Co., Ltd., Kyunggi-do (KR); Voronov, Alexander Legal & IP Team, Samsung SDI Co., Ltd., Kyunggi-do (KR); Roh, Cheol-Lae Legal & IP Team, Samsung SDI Co., Ltd., Kyunggi-do (KR)
(74) Representative: Hengelhaupt, Jürgen

(57) **Abstract**

A method of fabricating a polycrystalline silicon thin film transistor is disclosed. One embodiment of the method includes: forming an amorphous silicon layer on a panel; scanning a continuous wave laser beam having a wavelength range of about 600 to about 900 nm between a visible light range of a red color and a near infrared range onto the amorphous silicon layer to preheat the amorphous silicon layer; overlappingly scanning a pulse laser beam having a wavelength range of about 100 to about 550 nm between a visible light range and an ultraviolet range in addition to the continuous wave laser beam on the panel to melt the preheated amorphous silicon layer; and stopping scanning the pulse laser beam to crystallize the molten silicon layer.

## Description

### BACKGROUND OF THE INVENTION

### Field of the Invention

The present disclosure relates to a method of fabricating a polysilicon thin film transistor, and more particularly, to a method of fabricating a thin film transistor in which a combination of laser beams are overlappingly scanned to transform an amorphous silicon thin film into a polycrystalline silicon thin film.

### Description of the Related Technology

Flat panel display devices, such as an active matrix liquid crystal display, an electron emission display device, and an organic light emitting display, use thin film transistors (TFTs) to drive pixels. Most of TFTs include a channel formed of silicon. Silicon has higher field-effect mobility in a polycrystalline state than in an amorphous state. Therefore, it is possible to drive a flat panel display device at a high speed with silicon in a polycrystalline state.

The panels of the devices may be formed of amorphous silicon, quartz, glass, or a plastic material. A glass panel is widely used because it has certain advantages such as high transparency, low cost, and high productivity.

In order to transform amorphous silicon formed on a glass panel into crystalline silicon, a crystallization heat treatment process is performed in a temperature range in which the glass panel is not deformed. For example, a laser annealing method is used to fabricate polycrystalline silicon (i.e., low temperature polysilicon LTPS) in such a low temperature range. The laser annealing method is known as a more excellent technique than other low temperature crystallization techniques because of its low manufacturing costs and high efficiency.

Generally, an excimer laser has been used in the laser annealing method. In the excimer laser annealing method, since a selected wavelength range of the excimer laser is highly absorbed in amorphous silicon, the amorphous silicon can be easily heated and molten in a short period of time without damaging the panel to provide the polycrystalline silicon (also referred to as polysilicon or p-Si).

However, polysilicon obtained by the excimer laser annealing method has excessively low electron mobility. In addition, its grain size is not uniform in all TFTs. Thus, the excimer laser annealing method is not appropriate for polysilicon thin film transistors (p-Si TFTs) used in a high quality flat panel display device.

As a method for solving the aforementioned shortcomings of the excimer laser, a continuously oscillating (e.g. continuous wave (CW)) laser annealing method has been adopted. Since the CW laser annealing method can provide crystals having substantially no crystal grain aligned in the same direction as the laser injection direction, it is possible to fabricate p-Si TFTs having high electron mobility.

However, it is not easy to fabricate polycrystalline silicon having regular grain sizes on a large panel using the CW laser annealing method. In addition, a maximum power level that can be output from the CW laser is limited to a wavelength range in which the power of CW laser can be sufficiently absorbed in the silicon thin film. Therefore, the CW laser is not appropriate for mass production.

Furthermore, when a large-sized panel is fabricated using conventional laser annealing methods, the laser beam is scanned over the entire surface of the panel a plurality of times to obtain p-Si TFTs. In this case, the laser beam is duplicated scanned on part of the surface of the panel, and thus previously crystallized silicon may be molten again (i.e., recrystallized) in the duplicated area. The polysilicon recrystallized in the duplicated area has properties different from those of polysilicon that has not been recrystallized. As a result, polysilicon TFTs fabricated using the conventional laser heat treatment techniques may have different material properties even in a single panel. When a flat panel display device is fabricated using polysilicon TFTs having different material properties, defects such as a stripe may occur along the recrystallized silicon grains.

### SUMMARY OF THE INVENTION

One embodiment provides a method of fabricating a polycrystalline silicon thin film transistor. The method comprises: providing an amorphous silicon layer; applying a continuous wave laser beam having a wavelength of about 600 to about 900 nm onto the amorphous silicon layer for a first period; and applying a pulse laser beam having a wavelength of about 100 to about 550 nm onto the silicon layer for a second period within the first period such that the pulse laser beam at least partially overlaps with the continuous wave laser beam during the second period.

Preferably the continuous wave laser beam has a wavelength between 800 and 850 nm and the pulse laser beam has a wavelength between 500 nm and 550 nm.

Preferably the continuous wave laser beam has an intensity of 3 KW/cm² or less (more preferably of 0.1 to 3 KW/cm² and still more preferably of 1.5 to 3 KW/cm²) and/or preferably the pulse laser beam has a pulse fluence of 1 J/cm² or less (more preferably of 0.1 to 1 J/cm² and still more preferably of 0.5 to 1 J/cm²). Preferably the two laser beams were overlappingly scanned at a scan speed of 30 mm/sec or less to crystallize a silicon panel.

Each of the continuous wave laser beam and the pulse laser beam may be a line beam (or a stripe-like shaped beam), the line beam having a cross-section having a length and a width, the length being larger than the width. The width of the cross-section of the continuous wave laser beam may be larger than the width of the cross-section of the pulse laser beam. Applying the continuous wave laser beam may comprise scanning the continuous wave laser beam in a direction, and applying the pulse laser beam may comprise scanning the pulse laser beam in the direction.

The continuous wave laser beam may have a cross-section of a first size, and the pulse laser beam may have a cross-section of a second size smaller than the first size. The pulse laser beam may substantially completely overlap with the continuous wave laser beam. The continuous wave laser beam may have an energy level lower than an energy level required to melt the amorphous silicon layer. The substrate may be formed of glass or a plastic material.

Another embodiment provides a polycrystalline silicon thin film transistor made by the method described above. The transistor may comprise a silicon thin film including polycrystalline grains, the grains having an average size of about 10 µm or greater.

Yet another embodiment provides an electronic device comprising the above described polycrystalline silicon thin film transistor. The electronic device may comprise a display device. The display device may comprise an organic light emitting display device.

Another embodiment provides a method of making an electronic device. The method comprises: providing a partially fabricated electronic device comprising an amorphous silicon thin film; applying a continuous wave laser beam having a wavelength of about 600 to about 900 nm onto the amorphous silicon thin film for a first period; applying a pulse laser beam having a wavelength of about 100 to about 550 nm onto the thin film for a second period within the first period such that the pulse laser beam at least partially overlaps with the continuous wave laser beam during the second period, whereby at least part of the amorphous silicon thin film is converted to polysilicon; and further fabricating the partially fabricated electronic device so as to produce an electronic device comprising the polysilicon as part of an integrated circuit.

Applying the continuous wave laser beam may comprise using one selected from the group consisting of a semiconductor laser, a solid laser, and a gas laser. The semiconductor laser may be generated using a material selected from the group consisting of GaAs, GaAlAs, GaP, and GaAlAsP. Applying the pulse laser beam may comprise using one selected from the group consisting of a semiconductor laser, a solid laser, and a gas laser. The gas laser may be generated using a material selected from the group consisting of Ar, Kr, and CO₂.

Another embodiment provides a laser annealing method for crystallizing an amorphous silicon thin film, the method comprising: scanning a continuous wave laser beam onto an amorphous silicon thin film formed on a substrate, the continuous wave laser beam having a cross-section having a first width extending in a first direction; and periodically scanning a pulse laser beam onto the film such that the pulse laser beam at least partially overlaps with the continuous wave laser beam, the pulse laser beam having a cross-section having a second width extending in the first direction, the second width being shorter than the first width.

The continuous wave laser beam may have a wavelength of about 600 to about 900 nm. The pulse laser beam may have a wavelength of about 100 to about 550 nm.

Another embodiment provides a laser device for crystallizing an amorphous silicon thin film, comprising: a first laser oscillator for generating a pulse laser beam having a wavelength of about 100 to about 550 nm; a second laser oscillator for generating a continuous wave laser beam having a wavelength of about 600 to about 900 nm; and a laser optical system configured to scan the continuous wave laser beam and the pulse laser beam onto a scanning surface in the same direction such that the pulse laser beam at least partially overlaps with the continuous wave laser beam.

The second laser is preferably adapted for generating a continuous wave (CW) laser beam comprising a wavelength of 600, 610, 620, 630, 640, 650, 660, 670, 680, 690, 700, 710, 720, 730, 740, 750, 760, 770, 780, 790, 800, 810, 820, 830, 840, 850, 860, 870, 880, 890, 900 nm or a range that includes two of any of the foregoing values. The first laser oscillator is preferably adapted for generating a pulse laser beam comprising a wavelength of 100, 110, 120, 130, 140, 150, 160, 170, 180, 190, 200, 210, 220, 230, 240, 250, 260, 270, 280, 290, 300, 310, 320, 330, 340, 350, 360, 370, 380, 390, 400, 410, 420, 430, 440, 450, 460, 470, 480, 490, 500, 510, 520, 530, 540, 550 nm or a range that includes two of any of the foregoing values.

Another embodiment provides a method of fabricating a polycrystalline silicon thin film used in a thin film transistor, in which an amorphous silicon thin film deposited on a panel is reformed to a polycrystalline silicon thin film by scanning a combination of laser beams including a continuously oscillating (continuous wave CW) laser beam having a wavelength ranged between a visible light range of a red color and a near infrared range and a pulse laser beam having a wavelength ranged between a visible light range and an ultraviolet range.

Another embodiment provides a method of fabricating a polycrystalline silicon thin film transistor, including: forming an amorphous silicon layer on a panel; scanning a CW laser beam having a wavelength range of about 600 to about 900 nm between a visible light range of a red color and a near infrared range onto the amorphous silicon layer to preheat the amorphous silicon layer; overlappingly scanning a pulse laser beam having a wavelength range of about 100 to about 550 nm between a visible light range and an ultraviolet range in addition to the CW laser beam on the panel to melt the preheated amorphous silicon layer; and stopping scanning the pulse laser beam to crystallize the molten silicon layer.

The laser beams may be a line beam. A width W1 of the CW laser beam may be larger than a width W2 of the pulse laser beam. An energy level output from the CW laser beam may be lower than an energy level required to melt the amorphous silicon layer. The panel may be formed of a glass or a plastic.

Yet another embodiment provides a polycrystalline silicon thin film transistor including: a panel; a semiconductor layer formed on the panel to have source, drain, and channel regions; a gate electrode; and an insulation layer interposed between the semiconductor layer and the gate electrode, wherein the semiconductor layer is formed of a polycrystalline silicon thin film, and the polycrystalline silicon thin film is formed by initially crystallizing the amorphous silicon.

In addition, the channel region may be formed of a single crystal. The polycrystalline silicon thin film may be formed by performing an annealing method including overlappingly scanning a CW laser beam and a pulse laser beam.

Another embodiment provides a laser annealing method including: scanning a CW laser beam having a wavelength range of about 600 to about 900 nm between a visible light range of a red color and a near infrared range on an amorphous silicon thin film of a panel; and overlappingly and periodically scanning a pulse laser beam having a wavelength range of about 100 to about 550 nm between a visible light range and an ultraviolet range in addition to the CW laser beam scanned on the panel.

Another embodiment provides a laser annealing method for crystallizing an amorphous silicon thin film, including: scanning a CW laser beam having a width W1 onto the amorphous silicon thin film formed on a panel; and overlappingly and periodically scanning a pulse laser beam having a width W2 in addition to the CW laser beam scanned onto the panel, wherein the width W1 is larger than the width W2.

Another embodiment provides a laser device for crystallizing an amorphous silicon thin film, including: a first laser oscillator for generating a pulse laser beam having a wavelength range of about 100 to about 550 nm; a second laser oscillator for generating a CW laser beam having a wavelength range of about 600 to about 900 nm; and a laser optical system for simultaneously scanning the CW laser beam generated from the second laser oscillator and the pulse laser beam generated from the first laser oscillator onto a scanning surface in the same direction.

The first laser oscillator may include a green laser oscillator that generates a green laser beam having a wavelength of about 532 nm. The second laser oscillator may include a laser diode oscillator that generates a laser beam having a wavelength of about 808 nm.

### BRIEF DESCRIPTION OF THE DRAWINGS

The above and other features and advantages of the present disclosure will become more apparent by describing in detail exemplary embodiments thereof with reference to the attached drawings, in which:
Fig. 1 is a perspective view illustrating a laser beam scanned in a laser beam annealing method according to an embodiment;
Figs. 2A to 2E are conceptual diagrams illustrating a crystallization process in a laser annealing method according to an embodiment;
Fig. 3 is a conceptual diagram illustrating a crystallized state of the duplicated area generated as a result of the process of Fig. 2D;
Fig. 4 is a graph illustrating an absorption ratio of silicon crystals for a laser beam having a wavelength of 808 nm;
Fig. 5 is a schematic diagram comparing process efficiency when only a green pulse laser beam is scanned and when a continuous wave (CW) laser beam as well as a green pulse laser beam are overlappingly scanned;
Fig. 6 is a schematic diagram illustrating a crystallization process and a silicon panel fabricated thereby;
Figs. 7A to 7C are SEM photographs showing surfaces of silicon panels fabricated according to an embodiment and a comparative example;
Figs. 8A and 8B are photographs showing sizes of crystals grown according to an embodiment and in a single laser shot according to a comparative example;
Fig. 9 is a schematic diagram illustrating a laser optical system according to an embodiment; and
Fig. 10 is a cross-sectional view illustrating a thin film transistor fabricated according to an embodiment.

### DETAILED DESCRIPTION OF THE INVENTION

Hereinafter, a method of fabricating a polycrystalline silicon panel used in a thin film transistor according to an embodiment will be described in detail with reference to the accompanying drawings.

According to the invention "overlappingly scanned" means "CW LD laser beam 210" and "green laser beam 260" are overlappingly scanned and "duplicated" means a combination of the lasers (CW LD+green) scans the same area two times.

In this method, an amorphous silicon thin film deposited on a panel is transformed into a polycrystalline silicon thin film by scanning a combination of laser beams including a continuous wave (CW) oscillating laser beam having a wavelength range of about 600 to about 900 nm (particularly between a red color visible light range and a near infrared range) and a pulse laser beam having a wavelength range of about 100 to about 550 nm (particularly between a visible light range and an ultraviolet range). The continuous wave (CW) oscillating laser beam preferably comprises a wavelength of 600, 610, 620, 630, 640, 650, 660, 670, 680, 690, 700, 710, 720, 730, 740, 750, 760, 770, 780, 790, 800, 810, 820, 830, 840, 850, 860, 870, 880, 890, 900 nm or the wavelength is selected from at least one range, each range being generated of two of any of the foregoing values. The pulse laser beam preferably comprises a wavelength of 100, 110, 120, 130, 140, 150, 160, 170, 180, 190, 200, 210, 220, 230, 240, 250, 260, 270, 280, 290, 300, 310, 320, 330, 340, 350, 360, 370, 380, 390, 400, 410, 420, 430, 440, 450, 460, 470, 480, 490, 500, 510, 520, 530, 540, 550 nm or the wavelength is selected from at least one range, each range being generated of two of any of the foregoing values.

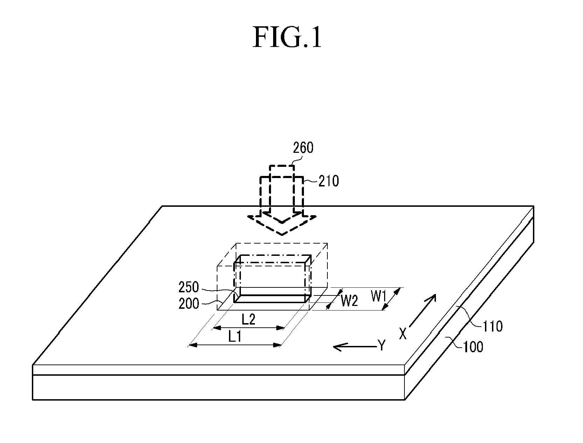

Fig. 1 is a perspective view illustrating a laser beam scanned in a laser beam annealing method according to an embodiment. Referring to Fig. 1, in a laser annealing method according to an embodiment, a continuous wave (CW) laser beam 210 and a pulse laser beam 260 are overlappingly scanned onto an amorphous silicon film 110 deposited on a panel 100.

The CW laser beam 210 has a wavelength range of about 600 to about 900 nm (between a red color visible light range and a near infrared range). In one embodiment, the CW laser beam 210 is a line beam irradiating an area 200 on the amorphous silicon film 110, the area 200 having a length L1 larger than a width W1. A source of the CW laser beam 210 may include a semiconductor laser such as a laser diode (LD), a solid laser, or a gas laser. The LD laser may include a GaAs laser, or a compound semiconductor laser such as GaAlAs, GaP, and GaAlAsP lasers. The solid laser may include an Nd:YAG laser or an Nd:YVO₄ laser.

The pulse laser beam 260 has a wavelength range of about 100 to about 550 nm (a visible light range or shorter). In one embodiment, the pulse laser beam 260 is a line beam irradiating an area 250 on the amorphous silicon film 110, the area 250 having a length L2 larger than a width W2. A source of the pulse laser 260 may include a gas laser, a semiconductor laser such as a laser diode (LD), or a solid laser. The gas laser may include an Ar laser, a Kr laser, and a CO₂ laser. The LD laser may include a GaAs laser, or a compound semiconductor laser such as GaAlAs, GaP, and GaAlAsP. The solid laser may include an Nd:YAG laser or an Nd:YVO₄ laser.

In the laser annealing method shown in Fig. 1, a semiconductor laser (e.g., a CW LD laser) having a wavelength of about 808 nm is used as a source of the CW laser 210, and a green laser having a wavelength of about 532 nm is used as a source of the pulse laser 260. Referring to Fig. 1, the width W1 and the length L1 of the CW LD laser beam 210 scanned onto the panel 100 may be larger than the width W2 and the length L2 of the green laser beam 260, respectively.

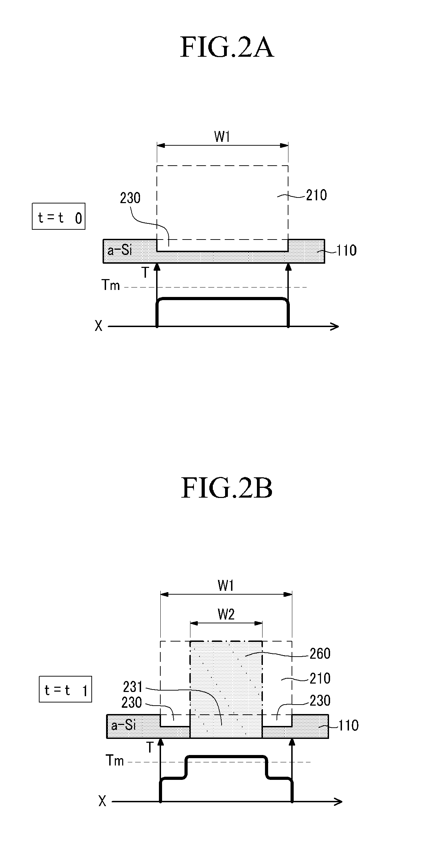

Now, the laser annealing method shown in Fig. 1 will be described in more detail with reference to Figs. 2A to 2E. Figs. 2A to 2E are conceptual diagrams illustrating a crystallization process of a laser annealing method according to an embodiment. In the laser annealing method shown in Fig. 1, the CW LD laser beam 210 (or the respective area) and the green laser beam 260 (or the respective area) are generated by separate laser sources, and overlappingly scanned onto the amorphous silicon thin film 110 on the panel 100.

First, referring to Fig. 2A (t = t0), the CW LD laser beam 210 is scanned onto the amorphous silicon thin film 110 to heat it in a short period of time. In this case, the temperature in the amorphous silicon thin film 110 is below the melting temperature Tm. Therefore, a region 230 of the amorphous silicon thin film where the CW LD laser beam 210 is incident is heated. Thus, the temperature of silicon in the region 230 increases, but the silicon is still in a solid state.

Then, referring to Fig. 2B (t=t1), the green laser beam 260 is scanned onto the amorphous silicon thin film 110 while the CW LD laser beam 210 is scanned. In this case, the temperature of the amorphous silicon thin film 110 is still below the melting temperature Tm in a region 230 where only the CW LD laser beam 210 is irradiated. However, the temperature of the amorphous silicon thin film 110 increases above the melting temperature in a region 231 where both the CW LD laser beam 210 and the green laser beam 260 are overlappingly irradiated.

As a result, the amorphous silicon thin film is molten in the region 231 where the CD LD laser beam 210 and the green laser beam 260 are overlappingly incident. In this case, the amorphous silicon thin film 110 is molten by the green laser beam 260, and thereby the CW LD laser beam 210 is more strongly absorbed in the molten amorphous silicon thin film region 231. Thus, the amorphous silicon thin film region 231 is substantially completely molten up to the surface of the panel 100.

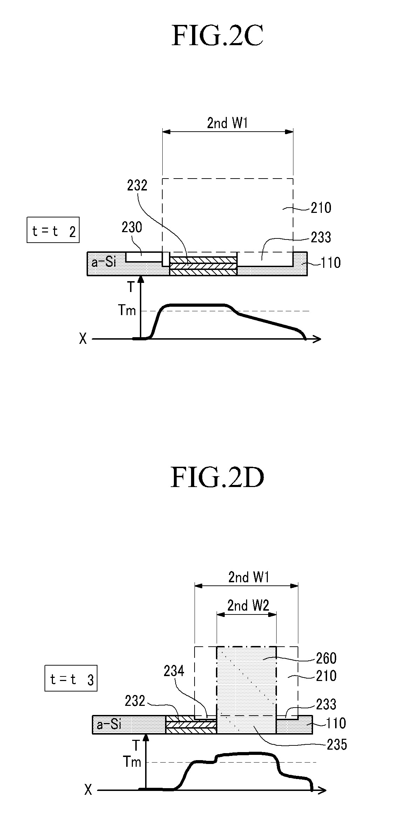

Referring to Fig. 2C (t = t2), while the CW LD laser beam 210 is scanned in an X-direction, scanning of the green laser beam 260 is terminated. In this case, the temperature distribution in the amorphous silicon thin film 110 is shifted along the moving direction (i.e., the X-direction) of the CW LD laser beam 210.

Therefore, the crystal 232 starts to grow in a lateral direction from the molten silicon region. However, since the CW LD laser beam 210 is continuously irradiated after the green laser beam 260 is turned off, the crystal 232 absorbs the CW LD laser beam 210, so that the cooling speed of the crystal is delayed.

As a result, the crystal 232 continuously grows to have a larger size. Since the CW LD laser beam 210 is continuously scanned onto the surface of the crystal 232, a shallow depth of the silicon remains in a molten state. In addition, the CW LD laser beam 210 moving in the X-direction heats a neighboring portion of the amorphous silicon region 233.

In this case, the CW LD laser beam 210 may be shifted by moving the laser beam itself or by moving the panel 100 relative to the laser beam. In one embodiment, the CW LD laser beam 210 is shifted by moving the panel 100.

Subsequently, referring to Fig. 2D (t = t3), the green laser beam 260 is scanned while the CW LD laser beam 210 is shifted several micrometers in the X-direction. In this case, the temperature in the amorphous silicon thin film 110 is below the melting temperature Tm in a region 234 where only the CW LD laser beam 210 is scanned. The temperature is above the melting temperature Tm in a region 235 where both the CW LD laser beam 210 and the green laser beam 260 are irradiated. As a result, the crystal 232 grown in a lateral direction can continuously grow due to such a temperature distribution.

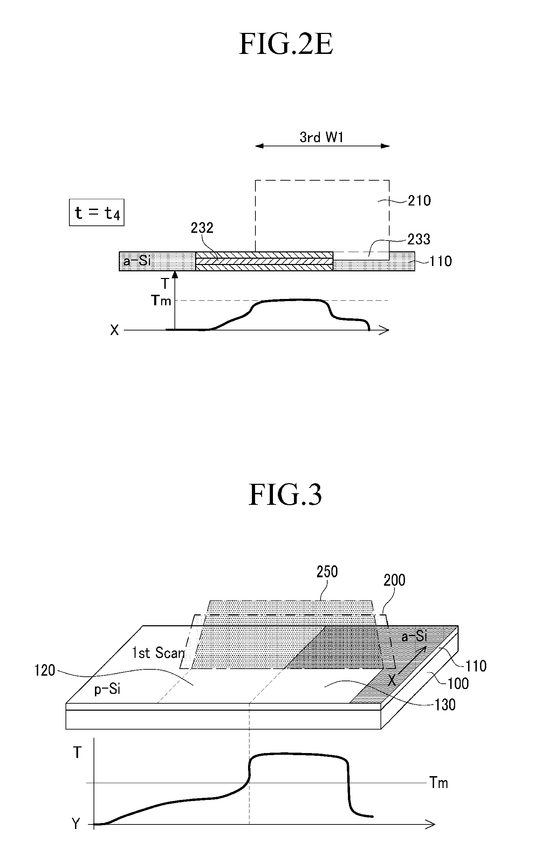

Referring to Fig. 2E (t = t4), scanning of the green laser beam 260 is terminated again while the CW LD laser beam 210 is further shifted in the X-direction. As described above, when the processes of Figs. 2A to 2E are repeatedly performed, the crystal 232 can continuously grow in a lateral direction.

Fig. 3 illustrates a case in which a combination of laser beams is secondly scanned onto the previously crystallized silicon layer 110. Also, Fig. 3 illustrates a temperature distribution near the duplicated area 120 where the combination of laser beams is scanned twice. Referring to Fig. 3, the temperature in the duplicated area 120 is below the melting temperature Tm of the silicon whereas the temperature in a non-duplicated area 130, which has been twice scanned, is above the melting temperature Tm.

Therefore, in the laser annealing method according to an embodiment, the crystallized silicon is not molten again by the first scanning of the combination of laser beams. Only the amorphous silicon region 130 that has not been crystallized is selectively molten and crystallized by the second scanning of the combination of laser beams. Thus, it is possible to selectively crystallize only the amorphous silicon thin film.

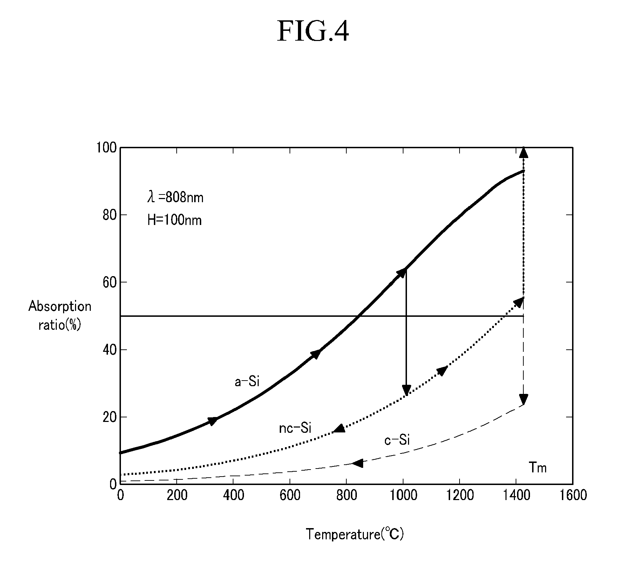

Now, selective crystallization only for the amorphous silicon thin film will be described in more detail. Silicon has a different laser absorption ratio depending on a crystallization state (amorphous or crystal) and a wavelength of light. An example will be described with reference to Fig. 4.

Fig. 4 illustrates an absorption ratio of a silicon crystal for a laser beam having a wavelength of 808 nm, where λ denotes a laser wavelength, H denotes a thickness of the amorphous thin film 110, a-Si denotes amorphous silicon, nc-Si denotes nano-crystallized silicon, and c-Si denotes crystallized silicon.

Referring to Fig. 4, the laser beam absorption ratio increases as the temperature increases, regardless of the crystallization state. However, the laser beam absorption ratio varies significantly depending on the crystallization state at the same temperature. Amorphous silicon has an absorption ratio of about 60% or higher, while crystalline silicon has an absorption ratio of about 20% or less at a temperature of about 1000°C. The reason is that, since the laser beam absorption ratio of the crystallized silicon is low, light passes through the crystallized silicon in the duplicated area 120 without being absorbed.

In addition, the green laser scanned in this case requires a relatively lower energy level in comparison to a case in which only the green laser beam is used similar to a conventional sequential lateral solidification (SLS) method. Therefore, when a second scanning is performed using the combination of laser beams, the incident green laser beam has an energy level lower than that of the SLS method in which only the green laser beam is used. Therefore, the crystallized silicon region 120 does not experience re-crystallization (in which melting and solidification are repeated). On the contrary, since the amorphous silicon has a high laser beam absorption rate, only the amorphous silicon region 130 is selectively heated, molten, and crystallized during the second laser beam scanning

As described above, even when a large sized panel is repeatedly scanned using a combination of laser beams in several round-trips, the duplicated area 120 is not re-molten. Therefore, only the amorphous silicon layer that has not been crystallized can be selectively crystallized.

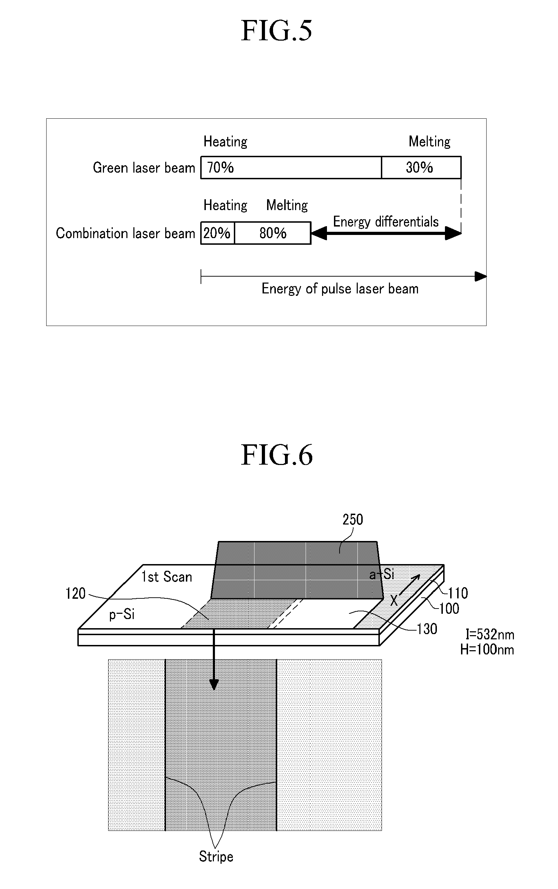

Fig. 5 illustrates process efficiencies when only the green pulse laser is used and when a combination of laser beams including the green laser beam and the CW LD laser beam is overlappingly used.

Referring to Fig. 5, assuming that the energy of the pulse laser beam required to crystallize amorphous silicon using only the green laser is set to 100%, about 70% of the energy is used to heat the silicon, and about 30% of the energy is used to melt it. On the contrary, the energy level of the green pulse laser beam required when a combination of laser beams including the CW LD laser beam and the green laser beam is used is about 50% or less of the energy level required when only the green laser beam is used.

In this case, about 20% of the energy of the green laser beam is used to heat the silicon, and about 80% of the energy is used to melt it. That is, since the CW LD laser beam of the combination of laser beams contributes to heating the amorphous silicon, most of energy of the green laser beam of the combination of laser beams is consumed to melt the amorphous silicon.

Now, a comparative example will be described. A case in which the amorphous silicon is crystallized using a combination of laser beams according to an embodiment and a case in which the amorphous silicon is crystallized using only the green laser beam in the SLS method will be compared with each other.

Fig. 6 illustrates a process of crystallizing an amorphous silicon thin film deposited in a thickness (H) of 100 nm on a glass panel, using only a green pulse laser beam having a wavelength (I) of 532 nm in the SLS method and a silicon thin film fabricated thereby. Referring to Fig. 6, since only the green laser beam is used, a high energy level sufficient to substantially completely melt the polysilicon for the crystallization is necessary. Therefore, successive scanning redundantly melts the already crystallized region 120 that is duplicated as well as the amorphous silicon region 130, and thus, the duplicated area 120 is recrystallized.

As a result, the polysilicon thin film fabricated thereby has defects such as a stripe shape in which the initially crystallized region and the recrystallized region are distinct. Accordingly, crystals of the entire surface of the panel are not uniform, and surface smoothness is also degraded.

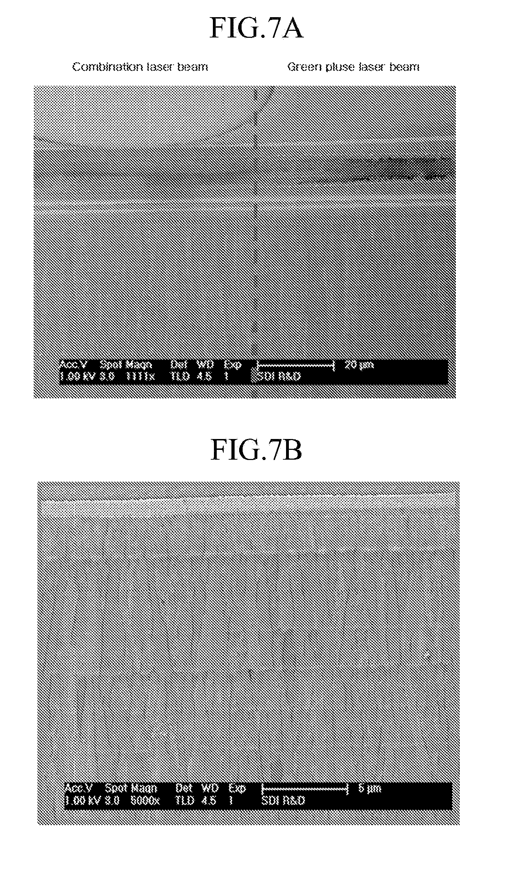

The left of Fig. 7A is a scanning electron microscope (SEM) photograph of a silicon thin film obtained by scanning a combination of laser beams on an amorphous silicon thin film deposited in a thickness of 100 nm on a glass panel. The right of Fig. 7A is an SEM photograph of a silicon thin film obtained by scanning an amorphous silicon thin film using only a green pulse laser beam.

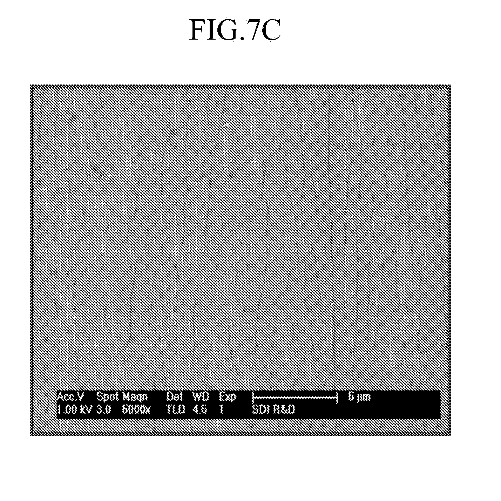

Fig. 7B is an enlarged view of the SEM photograph shown in the right of Fig. 7A, and Fig. 7C is an enlarged view of the SEM photograph shown in the left of Fig. 7A. An experiment of the embodiment shown in the left of Fig. 7A and in FIG. 7C was performed using a combination of laser beams including a CW LD laser beam having a wavelength of 808 nm and an intensity of 3 KW/cm² or less and a green pulse laser beam having a wavelength of 532 nm and a pulse fluence of 1 J/cm² or less. The laser beams were overlappingly scanned at a scan speed of 30 mm/sec or less to crystallize a silicon panel.

An experiment of the comparative example shown in the right of the Fig. 7A and in FIG. 7B was performed using only a green pulse laser beam having a wavelength of 532 nm and a pulse fluence of 1 J/cm² or less. The laser beam was scanned at a scan speed of 30 mm/sec or less to crystallize a silicon panel.

Referring to Figs. 7A to 7C, the panel fabricated using a method of scanning a laser beam according to an embodiment has substantially no defect such as a stripe, but the panel fabricated according to a comparative example has defects.

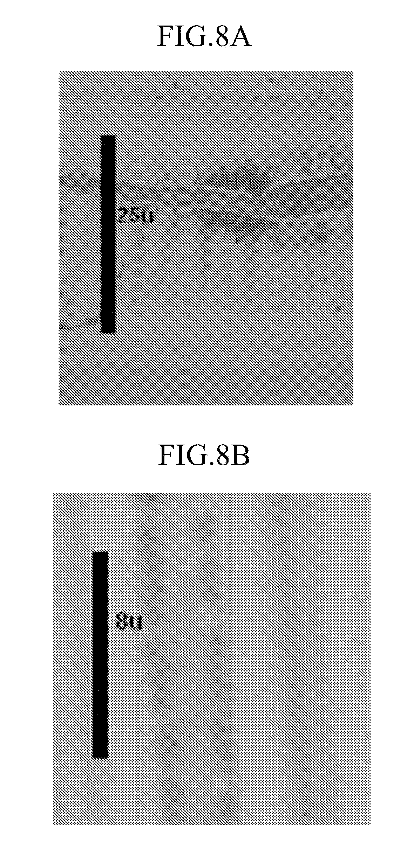

Fig. 8A is an SEM photograph showing a grain size in a lateral direction when a combination of laser beams according to an embodiment are scanned in a single shot, and Fig. 8B is an SEM photograph showing a grain size in a lateral direction when only a green pulse laser beam is scanned in a single shot.

Referring to Figs. 8A and 8B, the crystal can be grown in a larger size in a lateral direction using a laser annealing method according to an embodiment in comparison to a conventional laser annealing method in which only a green laser beam is used. Therefore, it is possible to provide higher productivity using a laser annealing method according to an embodiment in comparison to a conventional crystallization method.

As described above, the laser annealing methods according to the embodiments permit selectively crystallizing only amorphous silicon, but not previously crystallized silicon. Therefore, defects such as a stripe do not occur from the scanning. In addition, crystals can be indefinitely grown using the selective crystallization. For example, the polycrystalline grain of the channel region has an average size of about 10 µm or larger.

Furthermore, it is possible to minimize a grain boundary problem that obstructs drift of electrons or holes when adjacent crystal grains make contact with each other as a single crystal grain grows in a conventional SLS method. As a result, it is possible to fabricate a large sized flat display panel having high electron mobility by fabricating a TFT using a crystalline silicon panel according to an embodiment.

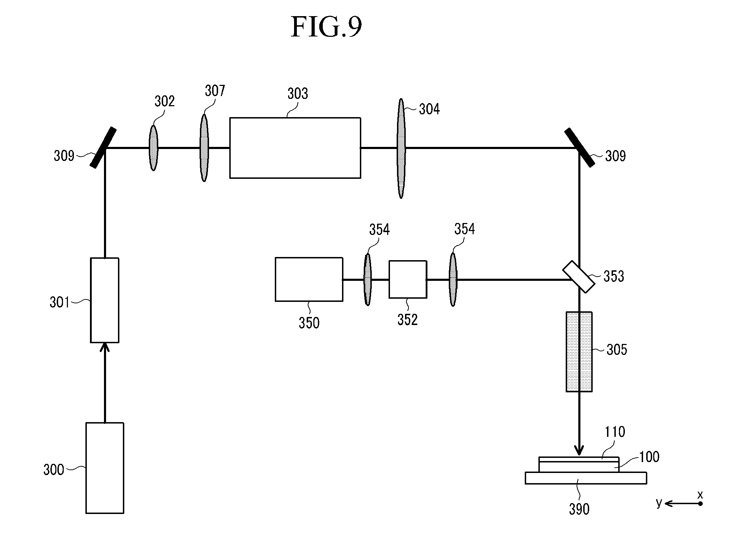

Now, a laser optical system for implementing a laser annealing method according to an embodiment will be described with reference to Fig. 9. Referring to Fig. 9, the laser optical system according to an embodiment includes a first laser oscillator 300 for generating a pulse laser beam having a wavelength range of about 100 to about 550 nm and a second laser oscillator 350 for generating a CW laser beam having a wavelength range of about 600 to about 900 nm.

The first laser oscillator 300 may include a gas laser, a semiconductor laser such as a laser diode (LD), or a solid laser. The gas laser may include an Ar laser, a Kr laser, or a CO₂ laser. The LD laser may include a GaAs laser, or a compound semiconductor laser such as GaAlAs, GaP, and GaAlAsP lasers. The solid laser may include an Nd:YAG laser or an Nd:YVO₄ laser.

In addition, the second laser oscillator 350 may include a semiconductor laser such as an LD laser, a gas laser, or a solid laser. The LD laser may include a GaAs laser or a compound semiconductor laser such as GaAlAs, GaP, and GaAlAsP lasers. The solid laser may include an Nd:YAG laser or an Nd:YVO₄ laser.

The CW laser beam generated in the second laser oscillator 350 is converted into a line beam in a second line beam generator 352. Then, its energy density is increased by a projecting lens 305. Then, the beam is scanned onto the panel 100 installed on a stage 390. Meanwhile, the intensity of the pulse laser beam generated in the first laser oscillator 300 is reduced in an optical attenuator 301, and the amount of light is amplified in a beam amplifier 302.

Then, the resulting laser beam is converted into a line beam in a first line beam generator 303, and is focused by a focusing lens 304. Subsequently, its energy density is increased by the projecting lens 305. Then, the beam is overlappingly scanned onto the panel 100 while the CW laser beam is also scanned.

The stage 390 is a transport device for positioning the panel 100 in the X and/or Y directions, and if necessary, in the Z direction (not shown) while the panel 100 is gripped.

Referring to Fig. 9, the reference numerals 309 and 353 denote mirrors for changing the optical paths of the laser beams. The reference numerals 307 and 354 denote lenses included in the laser optical system. Since the laser optical system shown in Fig. 9 is schematically illustrated in order to describe an embodiment, typical components of the laser optical system will not be described.

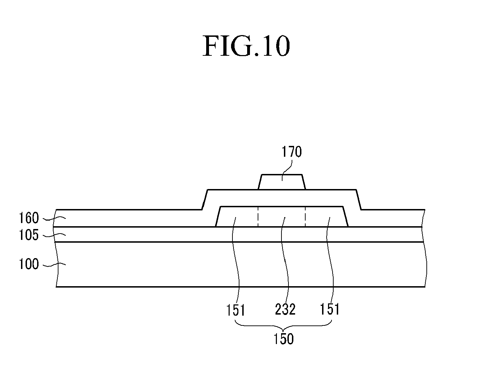

Now, a method of fabricating a p-Si TFT using the aforementioned laser annealing method and the laser optical system will be described with reference to Fig. 10. First, a panel 100 for fabricating the p-Si TFT is prepared. The panel 100 may be formed of a glass (e.g., barium borosilicate glass or aluminum borosilicate glass), quartz, silicon, a plastic material, and a metal (e.g., stainless steel). Preferably, a glass capable of resisting a high temperature is used according to one embodiment.

Subsequently, an amorphous silicon thin film 110 is formed on the panel 100. The amorphous silicon thin film may be deposited in a suitable thickness using any suitable method, such as PECVD, LPCVD, and sputtering. A buffer layer 105 formed of, for example, silicon oxide or silicon nitride may be provided between the panel 100 and the amorphous silicon thin film 110 depending on the type of the panel 100.

Subsequently, a laser annealing process is performed on the amorphous silicon thin film 110 using the laser optical system shown in Fig. 9. In the laser annealing, a combination of laser beams are overlappingly scanned onto the silicon thin film 110 using a green laser having a wavelength of about 532 nm as a first laser oscillator and a CW LD laser having a wavelength of about 808 nm as a second laser oscillator. During the laser annealing, the stage 390 is moved in the X and Y directions to successively scan the laser beams.

As a result, silicon that has already been crystallized is not molten, but only amorphous silicon can be selectively crystallized. Therefore, most of the silicon thin film that has been crystallized experiences only the first crystallization. If the second crystallization occurs depending on process variables such as deviations in condition of the laser annealing, the second crystallization is limited to about 5% or less of the entire surface of the panel area.

In the second crystallization, the silicon region that has already been crystallized is re-molten and recrystallized, so that the second crystallization region is crystallographically distinct from first crystallization region.

Subsequently, the crystallized silicon thin film 110 is patterned using a photolithographic method to provide a semiconductor layer 150. Then, a gate insulation film 160 is formed on the semiconductor layer 150. In this case, the gate insulation film may be formed in a suitable thickness using any suitable methods and materials such as silicon oxide or silicon nitride.

Subsequently, a gate electrode layer is formed on the gate insulation film 160. Then, a gate electrode 170, doped regions 151 of the semiconductor layer 150, and a channel region 232 are sequentially formed using photolithography or ion implantation. Subsequent processes for an interlayer insulation film, contact holes, and metallization are performed to provide a desired p-Si TFT. In addition, polycrystalline grains in the channel region have an average size of about 10 µm or larger.

The p-Si TFT fabricated according to an embodiment is used to fabricate a flat panel display device. Examples of the flat panel display device include an active matrix liquid crystal display (AMLCD) and an organic light emitting display (OLED). The p-Si TFT fabricated according to the embodiment may be used to drive and control individual pixels of the flat panel display devices.

According to the embodiments described above, a combination of laser beams including a continuous wave (CW) laser beam having a wavelength range of about 600 to about 900 nm between a visible light range of a red color and a near infrared range and a pulse laser beam having a wavelength range of about 100 to about 550 nm between a visible light range and an ultraviolet range are overlappingly scanned to transform an amorphous silicon thin film formed on the panel into a polycrystalline silicon thin film.

According to the embodiments described above, it is possible to increase crystallization efficiency of the low temperature poly-crystallization process in the laser annealing. In addition, according to the embodiments, it is possible to provide a polycrystalline silicon layer having experienced only the first crystallization by virtue of selective crystallization during the laser annealing. Therefore, it is possible to provide crystals having higher regularity and a relatively larger grain size than those known in the art.

Furthermore, since the p-Si TFTs fabricated according to the embodiment have high crystal regularity, it is possible to make performance of the TFTs constant. As a result, a system-on-panel (SOP) can be implemented in a flat panel display device.

Moreover, since a green pulse laser beam having an energy level lower than that of a typical green pulse laser beam can be used, the laser annealing can be performed using an inexpensive laser device. Accordingly, it is possible to fabricate the p-Si TFTs with high productivity and low manufacturing cost.

## Claims

1. A laser annealing method for crystallizing an amorphous silicon thin film, the method comprising:
scanning a continuous wave laser beam (210) onto an amorphous silicon thin film (110) formed on a substrate (100), the continuous wave laser beam (210) having a cross-section having a first width (W1) extending in a first direction; and periodically scanning a pulse laser beam (260) onto the amorphous silicon thin film (110) such that the pulse laser beam (260) at least partially overlaps with the continuous wave laser beam (210), the pulse laser beam (260) having a cross-section having a second width (W2) extending in the first direction, the second width (W2) being shorter than the first width (W1).

2. The method of claim 1, wherein the continuous wave laser beam (210) has a wavelength between 600 nm and 900 nm and/or wherein the pulse laser beam (260) has a wavelength between 100 nm and 550 nm.

3. The method according to one of the preceding claims, wherein each of the continuous wave laser beam (210) and the pulse laser beam (260) is a line-shaped beam, the line-shaped beam having a cross-section having a length (L1, L2) and a width (W1, W2), the length (L1, L2) being larger than the width (W1, W2).

4. The method according to one of the preceding claims, wherein the step of applying the continuous wave laser beam (210) comprises scanning the continuous wave laser beam (210) in a predetermined direction, wherein applying the pulse laser beam (260) comprises scanning the pulse laser beam (260) in the predetermined direction.

5. The method according to one of the preceding claims, wherein the pulse laser beam (260) completely overlaps with the continuous wave laser beam (210).

6. The method according to one of the preceding claims, wherein the continuous wave laser beam (210) has an energy density lower than an energy level required to melt the amorphous silicon layer (110) and/or wherein the superposed beam of the continuous wave laser beam (210) and the pulse laser beam (260) has an energy density higher than an energy level required to melt the amorphous silicon layer (110).

7. The method according to one of the preceding claims, wherein applying the continuous wave laser beam (210) comprises using a laser source selected from the group consisting of a semiconductor laser, a solid laser, and a gas laser.

8. The method according to claim 7, wherein the semiconductor laser is generated using a material selected from the group consisting of GaAs, GaAlAs, GaP, and GaAlAsP.

9. The method according to one of the preceding claims, wherein applying the pulse laser beam (210) comprises using a laser source selected from the group consisting of a semiconductor laser, a solid laser, and a gas laser.

10. The method according to claim 9, wherein the gas laser is generated using a material selected from the group consisting of Ar, Kr, and CO₂.

11. A method of fabricating a polycrystalline silicon thin film transistor, the method comprising:
crystallizing an amorphous silicon thin film (110) according to the method of claims 1-10;
wherein the continuous wave laser beam (210) is irradiated onto the amorphous silicon layer (110) for a first period; and the pulse laser beam (260) is irradiated onto the amorphous silicon layer (110) for a second period, the second period being located within the first period such that the pulse laser beam (260) at least partially overlaps with the continuous wave laser beam (210) during the second period,
forming source and drain regions in the crystallized silicon film,
forming a gate insulating layer, and
forming a gate electrode.

12. A method of making an electronic device, the method comprising:
crystallizing an amorphous silicon thin film (110) according to the method of claims 1-10;
wherein the continuous wave laser beam (210) is irradiated onto the amorphous silicon layer (110) for a first period; and the pulse laser beam (260) is irradiated onto the amorphous silicon layer (110) for a second period, the second period being located within the first period such that the pulse laser beam (260) at least partially overlaps with the continuous wave laser beam (210) during the second period,
further fabricating the partially fabricated electronic device by producing the electronic device using the crystallized silicon film as part of an integrated circuit.

13. A polycrystalline silicon thin film transistor producible by the method according to one of the claims 1-11.

14. The polycrystalline silicon thin film transistor of Claim 13, wherein the transistor comprises a silicon thin film including polycrystalline grains, the grains having an average size of 10 µm or greater.

15. An electronic device comprising the polycrystalline silicon thin film transistor producible by the method according to one of the claims 1-11.

16. The device of Claim 15, wherein the electronic device comprises a display device and/or wherein the display device comprises an organic light emitting display device.

17. A laser device for crystallizing an amorphous silicon thin film, comprising:
a first laser source (300) adapted for generating a pulse laser beam (260) having a wavelength between 100 and 550 nm;
a second laser source (350) adapted for generating a continuous wave laser beam (210) having a wavelength between 600 and 900 nm; and
a laser optical system configured to scan the continuous wave laser beam (210) and the pulse laser beam (260) onto a scanning surface of an amorphous silicon thin film (110) formed on a substrate (100) in the same direction such that the pulse laser beam (260) at least partially overlaps with the continuous wave laser beam (210).

18. The laser device according to claim 17, further comprising a stage (390) adapted for scanning the amorphous silicon thin film (110) formed on a substrate (100) in the same direction such that the pulse laser beam (260) at least partially overlaps with the continuous wave laser beam (210).
